(19) Europäisches Patentamt / European Patent Office / Office européen des brevets

(11) **EP 3 637 452 A1**

(12) **EUROPEAN PATENT APPLICATION**

(43) Date of publication:
**15.04.2020  Bulletin 2020/16**

(51) Int Cl.:
***H01J 37/153*** (2006.01)

(21) Application number: **18200039.8**

(22) Date of filing: **12.10.2018**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **FEI Company
Hillsboro, OR 97124-5793 (US)**

(72) Inventors:
• **Sluijterman, Albertus  Aemillius Seyno
5627 WH Eindhoven (NL)**
• **Bosch, Eric Gerardus Theodoor
5629 HB Eindhoven (NL)**
• **Henstra, Alexander
5602 BS Eindhoven (NL)**

(74) Representative: **Janssen, Francis-Paul
FEI Company
Patent Department
P.O.Box 1745
5602 BS Eindhoven (NL)**

(54) **CHARGED PARTICLE MICROSCOPE, AND METHOD FOR ADJUSTING A CHARGED PARTICLE MICROSCOPE**

(57)    The invention relates to a charged particle microscope for examining a specimen, and a method of calibrating a charged particle microscope. The charged particle microscope comprises an optics column, including a charged particle source, a final probe forming lens and a scanner, for focusing and scanning a beam of charged particles emitted from said charged particle source along an optical axis onto a specimen. Furthermore, a specimen stage is positioned downstream of said final probe forming lens and arranged for holding said specimen. Additionally, a detector device is provided, comprising at least two detector segment elements that are annularly spaced about said optical axis. A control unit is provided that is arranged for obtaining, for the at least two detector segment elements, corresponding detector segment images of said specimen by scanning the beam over said specimen. Based on a relative movement between the detector segment images, an aberration parameter of the charged particle microscope can be determined. The aberration parameter may be defocus, astigmatism and/or coma.

Fig. 4a

EP 3 637 452 A1

**Description**

The invention relates to a charged particle microscope, and to a method for adjusting a charged particle microscope, in particular for minimizing an aberration of the charged particle microscope.

Charged-particle microscopy is a well-known and increasingly important technique for imaging microscopic objects, particularly in the form of electron microscopy. Historically, the basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various subspecies, such as so-called "dual-beam" apparatus (e.g. a FIB-SEM), which additionally employ a "machining" Focused Ion Beam (FIB), allowing supportive activities such as ion-beam milling or Ion-Beam-Induced Deposition (IBID), for example.

In STEM, irradiation of a specimen by a scanning electron beam leads to interaction between the primary electrons and the sample. The interaction may lead to elastically scattered electrons exiting the sample, which may be detected to form a microscopic image. Additionally, irradiation of the specimen precipitates emanation of "auxiliary" radiation from the specimen, in the form of secondary electrons, backscattered electrons, X-rays and cathodoluminescence (infrared, visible and/or ultraviolet photons). One or more components of this emanating radiation may be detected and used for making microscope images.

For making microscope images using STEM, the charged particle beam needs to be well-focused and well-stigmated. For obtaining high quality microscope images, it is required that higher order aberrations are corrected.

Minimizing the aberrations ensures that the charged particle beam is brought to a fine point that reaches the specimen surface for obtaining sharp images. For setting focus, the user first of all needs to recognize that the beam is out of focus. Secondly, the user needs to determine which way to go for proper focusing: the user needs to determine whether the beam is over or under focused. This requires time and experience for setting the right focus.

When the charged particle microscope is well-stigmated, the charged particle beam is circular when it reaches the specimen. This, in combination with good focus, allows for accurate imaging. However, the probe cross section can be distorted to form an cross-hair like shape, due to various reasons. This distortion is called astigmatism and causes focus difficulties. To make the probe more circular, a stigmator may be used. Adjusting stigmation normally requires adjustment of two controls (which can have 45 degree and 90 degree orientation) that both can be above or below their optimum intensity. Setting stigmation well is difficult, especially for novice users.

A further challenge is posed by the fact that some specimens are fragile and may degrade over time as they are exposed to the charged particle beam. Thus, taking time to focus and stigmate the beam on the specimen may actually result in a lower quality specimen.

In view of the above, it is an object to provide an improved charged particle microscope. In particular, it is an object to provide a charged particle microscope that allows the user for easier, faster and/or improved focus and/or stigmation adjustment and/or adjustment of higher order aberrations.

According to an aspect, a charged particle microscope as defined by claim 1 is provided. The charged particle microscope comprises:

- an optics column, including a charged particle source, a final probe forming lens and a scanner, for focusing and scanning a beam of charged particles emitted from said charged particle source along an optical axis onto a specimen;
- a specimen stage positioned downstream of said final probe forming lens and arranged for holding said specimen;
- a detector device for detecting emissions originating from said specimen in response to the incidence of charged particles emitted from said charged particle source, and comprises at least two detector segment elements that are annularly spaced about said optical axis;
- a control unit for performing operations of the charged particle microscope.

The control unit of the charged particle microscope is arranged for determining at least one aberration parameter of said beam of charged particles onto said specimen, by:

- obtaining, for the at least two detector segment elements, corresponding detector segment images of said specimen by scanning the beam over said specimen;
- determining at least one image shift between mutual detector segment images; and
- relating said at least one image shift between said mutual detector segment images to said at least one aberration parameter.

By using a segmented detector that comprises at least two detector segment elements that are annularly spaced about the optical axis, at least two detector segment images, at different angular positions with respect to the optical axis, of the specimen are recorded simultaneously. These at least two detector segment images have a degree of similarity, but the images are actually shifted with respect to each other: this is visible in the images as an apparent relative movement of the specimen between the at least two detector segment images. This shift has been noted before by Kimoto and Ishizuka, and they attributed it to so called Rutherford scattering of an electron by a nucleus [Kimoto, K and Ishizuka, K (2011). Spatially resolved diffractometry with atomic-column resolution. Ultramicroscopy, 111, 1111-1116].

However, the inventors have found that the image shift actually contains information on a set of aberration parameters. Hence, the presence of an image shift of the imaged specimen, i.e. a relative movement, indicates that the charged particle microscope may not be focused and/or stigmated properly, which may be used to give valuable feedback to the user. STEM aberrations S in the specimen plane are described by a phase function

$$S(\omega, \bar{\omega}) = \text{Re}\left(\frac{1}{2}C_1\omega\bar{\omega} + \frac{1}{2}A_1\bar{\omega}^2 + B_2\omega^2\bar{\omega} + \frac{1}{3}A_2\bar{\omega}^3 + ..\right) \qquad (1),$$

in terms of the complex angle $\omega = \alpha + i\beta$ in the specimen plane (and its complex conjugate $\bar{\omega} = \alpha - i\beta$). The specified aberration coefficients are:

$C_1$ = defocus;
$A_1 = A_{1r} + i\,A_{1i}$ = astigmatism;
$B_2 = B_{2r} + i\,B_{2i}$ = coma; and
$A_2 = A_{2r} + i\,A_{2i}$ = 3-fold astigmatism.

The corresponding geometric aberrations in the specimen plane are given by:

$$\delta u = \delta x + i\,\delta y = 2\frac{\partial S(\omega, \bar{\omega})}{\partial \bar{\omega}} = C_1\omega + A_1\bar{\omega} + B_2\omega^2 + 2\bar{B}_2\omega\bar{\omega} + A_2\bar{\omega}^2 + .... \qquad (2).$$

The center of gravity $u_{\text{det}} = x_{\text{det}} + iy_{\text{det}}$ of a detector segment element is linked to its center of gravity in terms of angle $\omega_{det}$ via the camera length L:

$$u_{\text{det}} = \omega_{det}\,L \qquad (3).$$

The image shift $\delta u_{\text{det}}$ (in [meter]) is measured for N segments, i.e. it is measured for a set of detector angles $\omega_k$ with k = 1...N. Equation (2) then leads to a linear matrix equation, containing 2N equations. When there are more equations than unknowns the system is over-determined and a best fit for the aberration coefficients can be found by fitting the data using e.g. a least-squares method, singular value decomposition, a Levenberg-Marquardt method or any other available fitting algorithm as is well-known to the skilled artisan.

As an example, in case only focus (C1) and astigmatism (A1r + I A1i) are the relevant aberrations, equation (2) reduces to:

$$\begin{pmatrix} \delta x_1 \\ \delta y_1 \\ \delta x_2 \\ \delta y_2 \\ \vdots \\ \delta y_N \end{pmatrix} = \begin{pmatrix} \alpha_1 & \alpha_1 & \beta_1 \\ \beta_1 & -\beta_1 & \alpha_1 \\ \alpha_2 & \alpha_2 & \beta_2 \\ \beta_2 & -\beta_2 & \alpha_2 \\ \vdots & \vdots & \vdots \\ \beta_N & -\beta_N & \alpha_N \end{pmatrix} \begin{pmatrix} C_1 \\ A_{1r} \\ A_{1i} \end{pmatrix} \qquad (4),$$

In which $\alpha_k$ and $\beta_k$ are known, and $\delta x$ and $\delta y$ are measured from the image shifts. Thus the image shift between mutual detector segment images can be related to a predetermined set of aberration parameters, comprising at least one aberration parameter such as focus and astigmatism. The determined set of aberration parameters, which may be indicated by the charged particle microscope, may then be used by the user to change an adjustment setting of the charged particle microscope, such as focus and/or stigmatism. Alternatively, or additionally, the aberration parameter may be used by the control unit for adjusting a setting of the charged particle microscope. The charged particle microscope may be arranged to automatically change an adjustment setting of the charged particle microscope based on the obtained aberration parameter. Thus, with the aberration parameter obtained from the relative shift between images, a feedback mechanism, as well as the possibility of an improved setting of the charged particle microscope, in particular with respect to focus and/or stigmatism, becomes possible. With this, the object of the invention is achieved.

It is noted that the set of aberration parameters may relate in particular to a defocus, astigmatism, and/or coma. Additionally, the set of aberration parameters may comprise three-fold astigmatism or any other higher-order aberration.

In principle, the use of two detector segment elements at different angular positions merely allows the observation of an aberration parameter: it allows to measure the existence of an aberration, but it is hard to quantify the aberration. Quantifying the aberration is possible, however, when more than one exposure is made, and the detector segment elements are rotated about the optical axis, over 45°, for example. Thus, the method may in an embodiment comprise the step of pivoting the detector segment elements from the initial position to a second position in which at least one of the detector segment elements is positioned at a different angular position. Then, corresponding further detector segment images of said specimen may be obtained by scanning the beam over said specimen. This way, a set of at least three or four images are obtained: at least two detector segment images and at least one further detector segment image. This set of images may be used to determine image shifts that can be related to the at least one aberration parameter, i.e. to the set of aberration parameters.

As indicated in the example above, the set of images may be obtained by pivoting the detector segment elements. Alternatively, or additionally, the specimen may be pivoted to obtain the set of images (detector segment images and at least one further detector segment image at a different angular position). In general the use of additional exposures, for example at different rotation angles and/or different camera lengths by changing the excitation of the lenses between the specimen and the detector, can be beneficial in determining the set of aberrations.

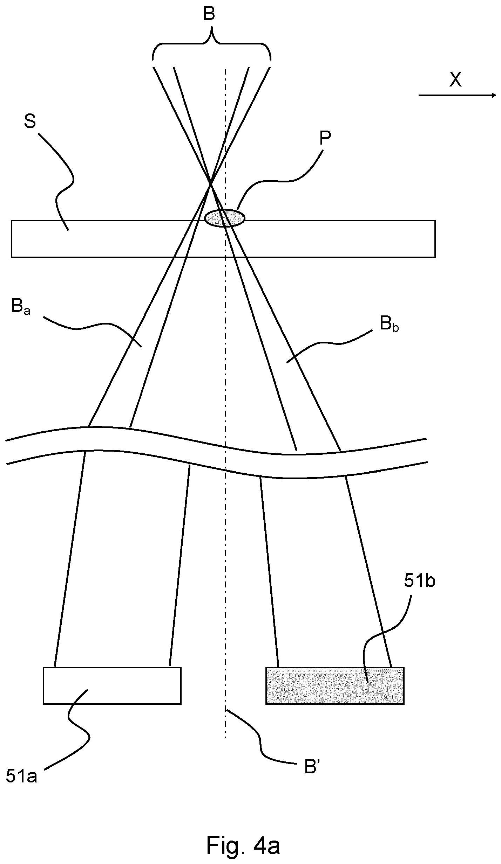

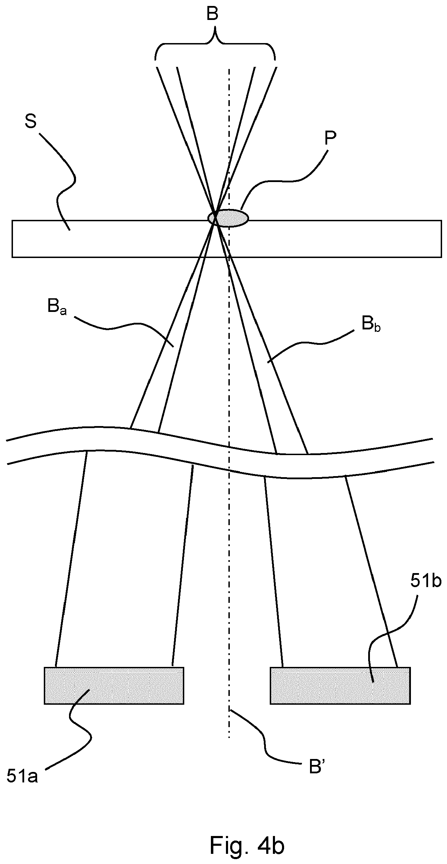

When at least three detector segment elements are used, and preferably at least four detector segment elements, said detector segment elements being annularly spaced about the optical axis, it is possible to quantify the aberration parameter. With three or four detector segment elements, not only information is obtained on the relative shift, but it also becomes possible to assign a direction in which the shift is taking place (for example, clockwise or counter-clockwise in relation to a clockwise sequencing of the available detector segment elements). To visualize this, the relative pixel shift between the detector segment images may be graphed in an x-shift versus y-shift graph. Each detector segment image has an x-shift and a y-shift, meaning that each detector segment image can be visualized as a single point in the x-shift versus y-shift graph. This also means that a parameter curve can be established for the relative pixel shift of subsequent detector segment images. The shape of the parameter curve (also referred to as shift image) can be round, oval, spiral-shaped, or irregular. The parameter curve may run clockwise or anti-clockwise, which gives at least information about defocus or astigmatism (see explanation with respect to Fig. 4a and 4b, later on).

As stated before, it was found that at ideal focus the relative movement is zero. In case the relative movement is not zero then the amplitude of the shifts is proportional to the defocus. In case the segment images are shown one by one, and the segments are sequenced clockwise, then the image shifts will also move clockwise. The difference between over and under focus is in the starting point of the clockwise movement. With a negative defocus the shift starts in phase with the detector segment, with a positive defocus it starts 180 degrees out of phase with the detector segments. Thus, from relative movement a defocus condition may be determined, and an adjustment may be made.

Thus it follows from the above that with a single scan it is possible to quantify the aberration as a defocus distance, including the direction in which to readjust.

In the above description of the parameter curve it was referred to a reference point. In the embodiment described above an assigned first detector segment element is appointed as reference point. As an alternative, the average of all image shifts may be assigned as reference point.

In an embodiment, the information derived from the at least two detector segment elements is used for creating one reference image, which may be used as reference point to create the above defined parameter curve.

It is noted in this regard that, although this is possible in an embodiment, it is not strictly necessary to use an image detector that is positioned on the optical axis. By having at least two or more annularly spaced detector segment elements it is already possible to determine mutual image shifts that can be related to an aberration of the charged particle microscope.

It is noted that by annularly spaced, it is meant that each of the detector segment elements has a different angular position, or -when viewed in cylindrical coordinates- a different angular coordinate. In this regard, the radial coordinate of the detector segment elements may be the same, or mutually different. In case the angular position is different, the image shift of the imaged specimen between mutual detector segment images is sufficient to determine an aberration of the charged particle microscope.

The determination of the at least one aberration parameter is improved in an embodiment, when said detector device comprises at least five detector segment elements that are annularly spaced about said optical axis. Said control unit may in this embodiment be arranged for determining at least defocus and astigmatism based on relative movement of the specimen between the subsequent detector segment images. It was found that at least five detector segment elements is sufficient to determine aberrations up to 2nd order. It is noted that in this case one of the detector segment elements may be provided as a central detector that is aligned with the optical axis, although precision is increased when five annularly spaced detector segment elements are used.

To be able to determine $3^{rd}$ and $4^{th}$ order aberrations, said detector device comprises, in an embodiment, at least one further detector segment element, wherein said further detector segment element is radially spaced with respect to said at least two detector segment elements.

It is noted that the use of a segmented detector is advantageous, as it is relatively cheap to install and data processing is relatively fast and accurate. The number of detector segment elements may, in an embodiment, be at most 64. It was found that with 64 detector segment elements determination of the set of aberration parameters is accurate and fast. Speed is improved when at most 48 segments are used. Additionally, this makes the detector in the microscope less complex, as less detector segment elements need to be installed and read out. In principle, an optimum between accuracy and complexity is found when the number of detector segment elements ranges between 8 and 24. It is noted that in principle it is possible to use a pixelated detector, i.e. having 256 x 256 pixels, in the method according to the invention, although they are relatively expensive and require more effort with respect to data processing.

According to an aspect, a method of adjusting a charged particle microscope is provided, said microscope comprising:

- an optics column, including a charged particle source, a final probe forming lens and a scanner, for focusing and scanning a beam of charged particles emitted from said charged particle source along an optical axis onto a specimen;
- a specimen stage positioned downstream of said final probe forming lens and arranged for holding said specimen; and
- a detector device for detecting emissions originating from said specimen in response to the incidence of charged particles emitted from said charged particle source, wherein said detector device comprises at least two detector segment elements that are annularly spaced about said optical axis.

The method comprises the steps of:

- obtaining, for the at least two detector segment elements, corresponding detector segment images of said specimen by scanning the beam over said specimen;
- determining at least one image shift between mutual detector segment images; and
- relating said at least one image shift between said mutual detector segment images to an aberration parameter.

With the determined aberration parameter, a correction may be applied to said charged particle microscope. Said correction may be a focus setting, a stigmation setting, and/or a coma setting, as indicated above. It is conceivable that threefold astigmatism can be corrected as well as higher order aberrations.

Advantages of the method have already been described with respect to the device according to the invention. The method may comprise the step of using a charged particle microscope according to one or more of the embodiments as described herein.

According to an aspect, a non-transitory computer readable medium is provided comprising instructions which, when executed by one or more hardware processors, cause performance of the method as described above.

The invention will next be explained by reference to the accompanying drawings, in which:

Fig. 1 - shows a longitudinal cross-sectional view of a charged particle microscope according to an embodiment of the invention;
Fig. 2 - shows a top view of a detector device according to an embodiment of the invention;
Fig. 3a and 3b - show a schematic overview of STEM imaging at three distinct positions, or "pixels";
Fig 4a to 4c - show a schematic overview of using a detector device according to the invention for determining an aberration parameter, at three different focus settings; and
Fig. 5a and 5b - show examples of parameter curves of relative XY-pixel shift of subsequent detector segment images.

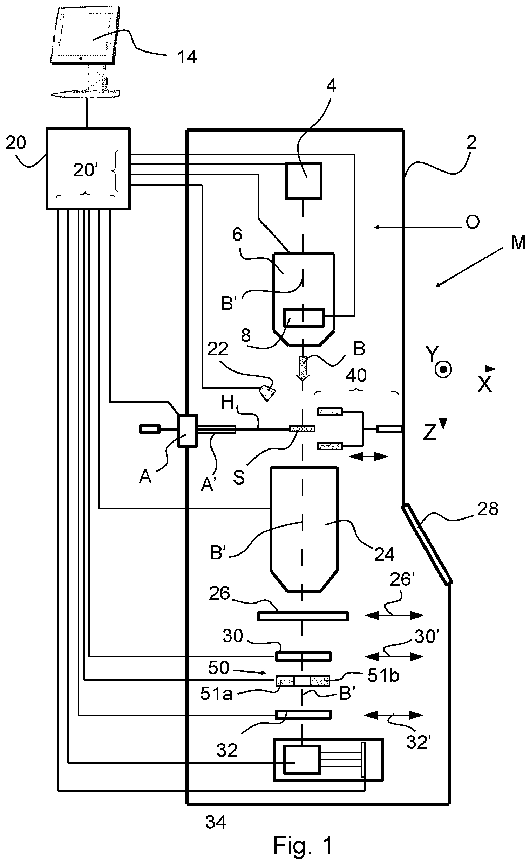

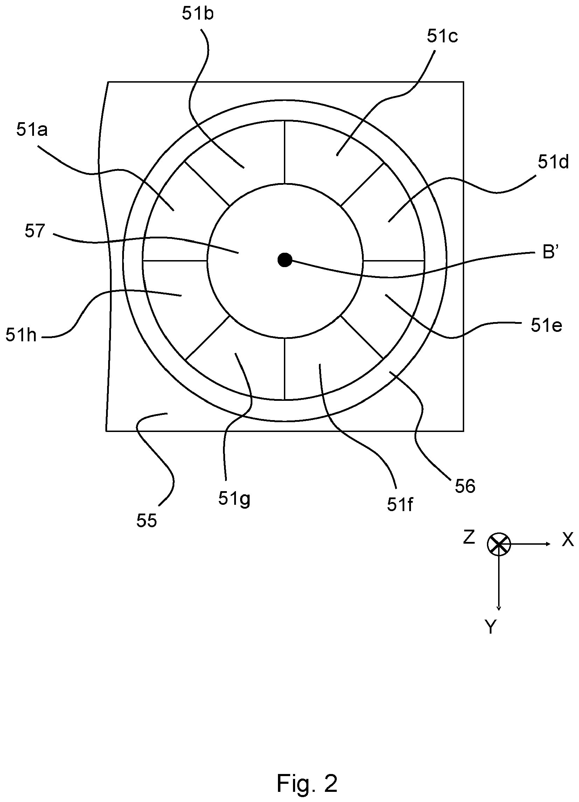

Fig. 1 (not to scale) is a highly schematic depiction of an embodiment of a charged-particle microscope M according to an embodiment of the invention. More specifically, it shows an embodiment of a transmission-type microscope M, which, in this case, is a TEM/STEM (though, in the context of the current invention, it could just as validly be a SEM (see Figure 2), or an ion-based microscope, for example). In Fig. 1, within a vacuum enclosure 2, an electron source 4 produces a beam B of electrons that propagates along an electron-optical axis B' and traverses an electron-optical illuminator 6, serving to direct/focus the electrons onto a chosen part of a specimen S (which may, for example, be (locally) thinned/planarized). Also depicted is a deflector 8, which (*inter alia*) can be used to effect scanning motion of the beam B.

The specimen S is held on a specimen holder H that can be positioned in multiple degrees of freedom by a positioning device / stage A, which moves a cradle A' into which holder H is (removably) affixed; for example, the specimen holder H may comprise a finger that can be moved (*inter alia*) in the XY plane (see the depicted Cartesian coordinate system; typically, motion parallel to Z and tilt about X/Y will also be possible). Such movement allows different parts of the specimen S to be illuminated / imaged / inspected by the electron beam B traveling along axis B' (in the Z direction) (and/or allows scanning motion to be performed, as an alternative to beam scanning). If desired, an optional cooling device (not depicted) can be brought into intimate thermal contact with the specimen holder H, so as to maintain it (and the specimen S thereupon) at cryogenic temperatures, for example.

The electron beam B will interact with the specimen S in such a manner as to cause various types of "stimulated" radiation to emanate from the specimen S, including (for example) secondary electrons, backscattered electrons, X-rays and optical radiation (cathodoluminescence). If desired, one or more of these radiation types can be detected with the aid of analysis device 22, which might be a combined scintillator/photomultiplier or EDX (Energy-Dispersive X-Ray Spectroscopy) module, for instance; in such a case, an image could be constructed using basically the same principle as in a SEM. However, alternatively or supplementally, one can study electrons that traverse (pass through) the specimen S, exit/emanate from it and continue to propagate (substantially, though generally with some deflection/scattering) along axis B'. Such a transmitted electron flux enters an imaging system (projection lens) 24, which will generally comprise a variety of electrostatic / magnetic lenses, deflectors, correctors (in particular stigmators), *etc.* In normal (non-scanning) TEM mode, this imaging system 24 can focus the transmitted electron flux onto a fluorescent screen 26, which, if desired, can be retracted/withdrawn (as schematically indicated by arrows 26') so as to get it out of the way of axis B'. An image (or diffractogram) of (part of) the specimen S will be formed by imaging system 24 on screen 26, and this may be viewed through viewing port 28 located in a suitable part of a wall of enclosure 2. The retraction mechanism for screen 26 may, for example, be mechanical and/or electrical in nature, and is not depicted here.

As an alternative to viewing an image on screen 26, one can instead make use of the fact that the depth of focus of the electron flux leaving imaging system 24 is generally quite large (*e.g.* of the order of 1 meter). Consequently, various other types of analysis apparatus can be used downstream of screen 26, such as:

- TEM camera 30. At camera 30, the electron flux can form a static image (or diffractogram) that can be processed by controller/processor 20 and displayed on a display device (not depicted), such as a flat panel display, for example. When not required, camera 30 can be retracted/withdrawn (as schematically indicated by arrows 30') so as to get it out of the way of axis B'.
- STEM camera 32. An output from camera 32 can be recorded as a function of (X,Y) scanning position of the beam B on the specimen S, and an image can be constructed that is a "map" of output from camera 32 as a function of X,Y. Camera 32 can comprise a single pixel with a diameter of *e.g.* 20 mm, as opposed to the matrix of pixels characteristically present in camera 30. Moreover, camera 32 will generally have a much higher acquisition rate (*e.g.* $10^6$ points per second) than camera 30 (*e.g.* $10^2$ images per second). Once again, when not required, camera 32 can be retracted/withdrawn (as schematically indicated by arrows 32') so as to get it out of the way of axis B' (although such retraction would not be a necessity in the case of a donut-shaped annular dark field camera 32, for example; in such a camera, a central hole would allow flux passage when the camera was not in use).
- As an alternative to imaging using cameras 30 or 32, one can also invoke spectroscopic apparatus 34, which could be an EELS module, for example.

It should be noted that the order/location of items 30, 32 and 34 is not strict, and many possible variations are conceivable. For example, spectroscopic apparatus 34 can also be integrated into the imaging system 24.

In the embodiment shown, the microscope M further comprises a retractable X-ray Computed Tomography (CT) module, generally indicated by reference 40. In Computed Tomography (also referred to as tomographic imaging) the source and (diametrically opposed) detector are used to look through the specimen along different lines of sight, so as to acquire penetrative observations of the specimen from a variety of perspectives.

For many of the above analysis apparatuses 26, 30, 32, 34, 40 correct focus and stigmatism is required, or at least desired. For enabling an improved microscope setting, in particular a focus and/or stigmation setting, that can be obtained in a more easier way, with more accuracy and/or speed by a user, a detector device 50 is provided. The detector device may be positioned in clear line of sight of said specimen, meaning that the detector segment elements are substantially completely illuminated by the beam, which may or not be filtered beam. In other words, in between the specimen and the detector device, the charged particle device is free from beam-limiting objects. This detector device 50 comprises at least two detector segment elements 51a, 51b, which are annularly provided about optical axis B', meaning that they are positioned at mutually different angular positions, and with a radial offset with respect to the optical axis B'. This provides a plurality of detector segment elements 51a, 51b that are each comparable to STEM detector 32 as described above, i.e. this provides a plurality of STEM sensor pixels that are radially spaced from the optical axis B' and spaced from each other in a circumferential direction about the optical axis B'. This means that each detector segment element 51a, 51b is arranged for recording a signal as a function of (X, Y) scanning position of the beam B on the specimen S (i.e. scanning pixels). This way, for each detector segment element 51a, 51b an image can be constructed that is a "map" of output from the respective detector segment element as a function of X,Y. This allows the images from different detector segment elements 51a, 51b to be compared to each other, i.e. mapped onto each other, and based on relative (X, Y) movement between the different detector segment images, an aberration parameter can be determined. A more detailed explanation of the detector device 50, and how it may be used in determining at least one aberration parameter will be given later on with reference to Fig. 2 and Figs. 4a-4c, respectively.

It is noted that the controller (computer processor) 20 is connected to various illustrated components *via* control lines (buses) 20'. This controller 20 can provide a variety of functions, such as synchronizing actions, providing setpoints, processing signals, performing calculations, and displaying messages/information on a display device (not depicted). Needless to say, the (schematically depicted) controller 20 may be (partially) inside or outside the enclosure 2, and may have a unitary or composite structure, as desired.

The skilled artisan will understand that the interior of the enclosure 2 does not have to be kept at a strict vacuum; for example, in a so-called "Environmental TEM/STEM", a background atmosphere of a given gas is deliberately introduced / maintained within the enclosure 2. The skilled artisan will also understand that, in practice, it may be advantageous to confine the volume of enclosure 2 so that, where possible, it essentially hugs the axis B', taking the form of a small tube (*e.g.* of the order of 1 cm in diameter) through which the employed electron beam passes, but widening out to accommodate structures such as the source 4, specimen holder H, screen 26, camera 30, camera 32, spectroscopic apparatus 34, *etc.*

The charged particle microscope M according to the invention, and of which an embodiment is shown in Fig. 1, thus at least comprises an optics column O, including a charged particle source 4, a final probe forming lens 6 and a scanner 8, for focusing and scanning a beam B of charged particles emitted from said charged particle source 4 along an optical axis B' onto a specimen. The apparatus further comprises a specimen stage A,H positioned downstream of said final probe forming lens 6 and arranged for holding said specimen S. The apparatus M furthermore comprises a detector device 50 for detecting emissions originating from said specimen in response to the incidence of charged particles emitted from said charged particle source. As described before, this detector device 50 comprises at least two detector segment elements 51, 51b that are annularly spaced about said optical axis B'. Additionally, the apparatus comprises a control unit 20 that is at least connected (by means of lines 20') to said detector device 32, as well as to other relevant parts of the charged particle microscope M, for performing operations of the charged particle microscope M. According to the invention, said control unit 20 is arranged for determining at least one aberration parameter of said beam B of charged particles onto said specimen S, by:

- obtaining, for the at least two detector segment elements 51a, 51b, corresponding detector segment images of said specimen by scanning the beam over said specimen S; and
- determining at least one image shift of the imaged specimen between mutual detector segment images; and
- relating said at least one image shift between said mutual detector segment images to an aberration parameter of the charged particle microscope M.

Now turning to Fig. 2, an embodiment of the detector device 50 is shown. The detector device 50 comprises a total of eight detector segment elements 51a-51h. These eight detector segment elements 51a-51h are annularly spaced with respect to the optical axis B', which runs parallel to coordinate axis Z. The detector segment elements 51a-51h are connected to a plate-like holder 55 by means of connector element 56. In the center of the detector device 50, a hole 57 is provided.

It is noted that in principle the detector device may comprise only two detector segment elements which is sufficient to visualize a relative movement, which can be used to determine an aberration parameter. To be more precise: in case of relative movement, an aberration is present. When there is no relative movement, then it is quite likely that the settings of the microscope are such that no aberration is present. With increasing number of detector segment elements, it is possible to quantify the aberrations more precisely, and to distinguish between different aberrations. With five segments it is possible to determine aberrations up to 2nd order. With additional detector segment elements that are positioned on various radial positions, it is possible to determine aberrations up to 4th order. In an embodiment, with which 4th order aberrations are detectable, the detector may comprise two radially spaced rings of detector segment elements, wherein in each ring the detector segment elements are radially spaced. Here, a total of 9 detector segment elements may be used.

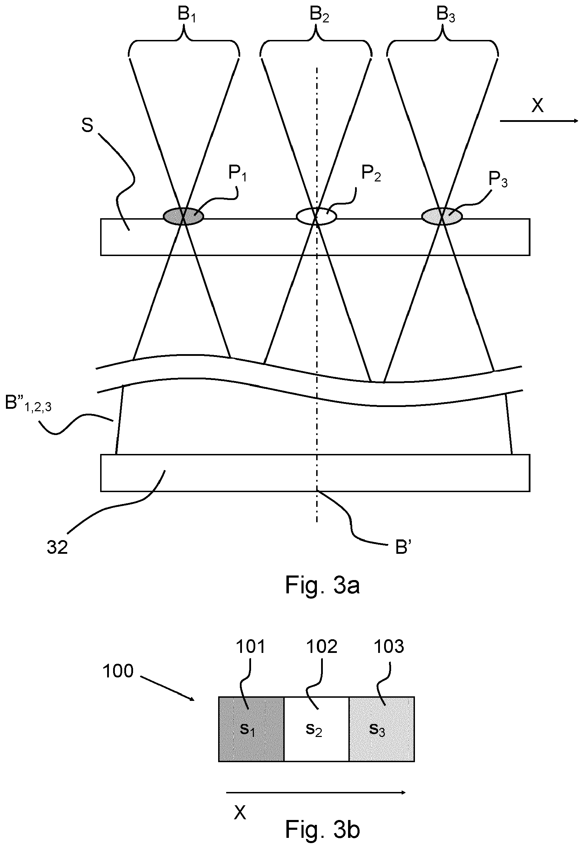

To explain the function of the detector device 50 with its detector segment elements 51, it is first referred to Fig. 3a and Fig. 3b, which shows a simplified diagram of a prior art STEM camera 32 receiving transmitted beams B"$_{1,2,3}$ emanating from three individual beams $B_1$, $B_2$, $B_3$ at separate positions on a specimen S - which is a result from scanning the beam in a X-direction. The specimen S has characteristic points $P_1$, $P_2$, $P_3$ at each of the three separate positions: one dark $P_1$, one light $P_2$, and one grey $P_3$, and thus as the beam progresses along the X-direction, the camera 32 will receive a different signal due to the fact that the characteristic points influence the beams $B_1$, $B_2$, $B_3$ in different ways. Fig. 3b shows a simplified output from camera 32, as it receives beams B"$_{1,2,3}$ as a function of X-scanning position of the beam $B_1$-$B_3$ on the specimen S, as a 1D-image 100 with image pixels 101-103. As the beam is scanned from left to right over the specimen S, the beam will first encounter "dark" characteristic point $P_1$ at a first position B1, which the STEM camera 32 will detect as a "dark" signal $s_1$, resulting in a "dark" pixel 101 in the image 100. At a second position $B_2$, the beam will encounter a "light" characteristic point $P_2$, which the camera 32 will detect as a "light" signal, and is output as a "light" pixel 102 in the image 100. At the third position $B_3$, the beam will encounter a "medium" characteristic point $P_3$, which in turn is detected by the camera 32 as a "medium" signal, and is output as a medium pixel 103 in the image 100. Hence, scanning the beam over the specimen S and recording the output provided by the detector 32 at each position, and mapping that output in a 1D image (the mapped output image 100), shows a representation of the specimen S in an image 100. In a similar manner, it will be clear that a 2D image representative of the specimen can be made.

Now turning to Fig. 4a, a schematic overview of a beam B illuminating a specimen S having a characteristic point P is shown. Here, a detector device 50 according to the invention is used, having two detector segment elements spaced apart from each other (in circumferential or annular direction), and radially with respect to the optical axis B'. Each detector segment element receives a different beam part $B_a$, $B_b$ from the beam B. The beam is out of focus, and in this case the focal point lies above the specimen S.

Now, when the beam is scanned from left to right, it follows that the beam part $B_b$ associated with the right detector 51b is transmitted through the characteristic point P, whilst the beam part $B_a$ associated with the right detector 51a is not transmitted through the specimen S. Hence, at a given position of the beam B, the first detector segment element 51a returns a white signal, and the second detector segment element 51b returns a grey signal. Likewise, when the beam continues scanning, there will be a point where the first beam part $B_a$ is transmitted through the characteristic point P, but the second beam part $B_b$ isn't. Hence, at that position the first detector segment element 51a returns a grey signal, and the second detector segment element 51b returns a white signal. Thus, when the mapped output images (see description of Fig. 3a and 3b) of the detector segment elements are compared to each other, there will be a relative movement of the characteristic point P. Of course, there will also be some amount of blurring to the detector segment images as a consequence of the defocus.

Now looking at Fig. 4b, a correctly focused beam B is shown, with its focus point exactly on the surface of the specimen S. This means that during scanning of the beam in X-direction, the beam parts $B_a$ and $B_b$ will (almost) simultaneously reach the characteristic point, such that the detector segment elements 51a, 51b will both register the grey characteristic point in the mapped output images at the same position of the beam. Thus, in the mapped output images of the two detector segment elements, there will be no relative shift of the characteristic point: the beam is in focus. Thus, this allows the user to evaluate whether there is correct focus with a simple comparison of two images. In the device according to the invention, the controller may establish the mapped output images and compare them to see whether there is correct focus, and provide a feedback to the user.

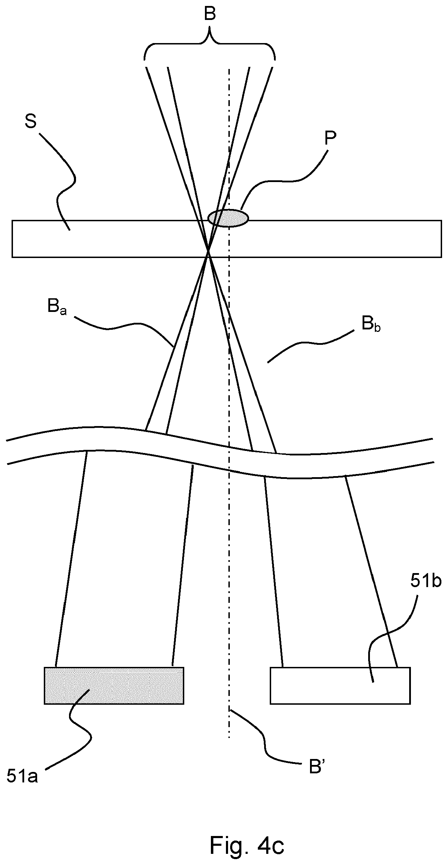

Now turning to Fig. 4c, a similar situation as the situation in Fig. 4a is shown, but here the focus point lies within the specimen S, below the characteristic point P. This will still lead to a relative movement of the specimen S in the different mapped output images. Compared to Fig. 4a, however, the situation is exactly opposite. Here, the first beam part $B_a$ will reach the characteristic point first, and thus the mapped output image will show a grey point first for the first detector 51a. This is exactly opposite to the situation shown in Fig. 4a, where the first beam part $B_a$ reaches the characteristic point later than the second beam part $B_b$. This means that from the direction of the relative movement, it can be inferred whether the beam is over-focused or under-focused.

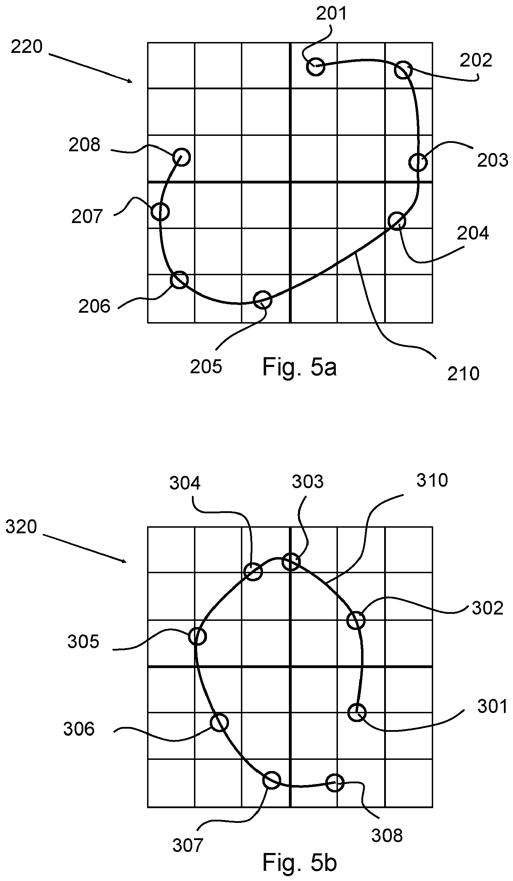

Fig 5a and 5b show examples of parameter curves obtained with a detector device having eight detector segment elements. For each detector segment element a corresponding XY pixel shift is determined. The XY pixel shift is entered into the diagram 220, 320, as a corresponding point 201-208; 301-308 for each detector segment element, and adjacent detector segment elements are connected with a parameter curve 210, 310.

In Fig. 5a, the starting point 201 is to the top, and a bit to the right. Following adjacent detectors (in, for example, a clockwise direction on the detector device) shows a clockwise movement of the pixel shift 210. The graph 210 has a nice oval shape. From the actual pixel shift (and the clockwise direction) it is possible to determine an aberration setting, and in this case it is possible to determine focus, and/or astigmatism and coma (using, for example, an equation similar to eq. 1 and/or eq. 2 as described above). Likewise, graph 310 (Fig. 5b) shows a counter clockwise movement of pixel shifts 301-308, starting in the lower right hand side of the graph 320.

Analysis of the parameter curve for finding a desired aberration parameter, such as focus, astigmatism and/or coma, will result in an improved setting of the charged particle microscope. It is noted that in solving for the desired aberration parameter, it is possible to use the equations (1) and/or (2) as depicted above. It will be understood by those skilled in the art that, in line with equations (1) and/or (2), similar equations can be derived for any desired aberration parameter, such as focus, astigmatism, coma, and/or threefold astigmatism, as a function of the number of detector segment elements and the relative pixel shift between the detector segment elements.

Above, the invention has been explained with reference to exemplary embodiments. The desired protection is conferred by the appended claims.

**Claims**

1.  A charged particle microscope for examining a specimen, comprising:

    - an optics column, including a charged particle source, a final probe forming lens and a scanner, for focusing and scanning a beam of charged particles emitted from said charged particle source along an optical axis onto a specimen;
    - a specimen stage positioned downstream of said final probe forming lens and arranged for holding said specimen;
    - a detector device for detecting emissions originating from said specimen in response to the incidence of charged particles emitted from said charged particle source, wherein said detector device comprises at least two detector segment elements that are annularly spaced about said optical axis;
    - a control unit for performing operations of the charged particle microscope; **characterized in that** said control unit is arranged for determining at least one aberration parameter of said beam of charged particles onto said specimen, by:
    - obtaining, for the at least two detector segment elements, corresponding detector segment images of said specimen by scanning the beam over said specimen; and
    - determining at least one image shift between mutual detector segment images; and
    - relating said at least one image shift between said mutual detector segment images to said at least one aberration parameter.

2.  A charged particle microscope according to claim 1, wherein said detector device comprises at least three detector segment elements that are annularly spaced about said optical axis.

3.  A charged particle microscope according to any one of the previous claims, wherein said control unit is arranged for using said aberration parameter for applying an adjustment setting to said charged particle microscope.

4.  A charged particle microscope according to any one of the previous claims, wherein said detector device comprises at least five annularly spaced detector segment elements.

5.  A charged particle microscope according to any one of the previous claims, wherein said detector device comprises at least eight annularly spaced detector segment elements, and wherein said control unit is arranged for determining at least defocus and astigmatism based on at least one mutual image shift between the subsequent at least eight detector segment images.

6.  A charged particle microscope according to any one of the previous claims, wherein said detector device comprises at least one further detector segment element, wherein said further detector segment element is placed at a different radius with respect to the optical axis compared to the said at least two detector segment elements.

7.  A charged particle microscope according to any one of the previous claims, wherein said detector device and said control unit are configured for determining one or more aberrations chosen from the group comprising: focus, astigmatism, coma, and threefold astigmatism.

8.  Method of adjusting a charged particle microscope comprising:

    - an optics column, including a charged particle source, a final probe forming lens and a scanner, for focusing and scanning a beam of charged particles emitted from said charged particle source along an optical axis onto a specimen;
    - a specimen stage positioned downstream of said final probe forming lens and arranged for holding said specimen;
    - a detector device for detecting emissions originating from said specimen in response to the incidence of charged particles emitted from said charged particle source, wherein said detector device comprises at least two detector segment elements that are annularly spaced about said optical axis;

    wherein the method comprises the steps of:

    - obtaining, for the at least two detector segment elements, corresponding detector segment images of said specimen by scanning the beam over said specimen;

- determining at least one image shift between mutual detector segment images; and
- relating said at least one image shift between said mutual detector segment images to an aberration parameter.

9. Method according to claim 8, using a charged particle microscope as defined in any one of the claims 1-7.

10. Method according to claim 8 or 9, comprising the step of pivoting the detector segment elements from the initial position to a second position in which at least one of the detector segment elements is positioned at a different angular position, wherein corresponding further detector segment images of said specimen may be obtained by scanning the beam over said specimen.

11. Method according to claim 8, 9 or 10, comprising the step of changing the camera length, wherein corresponding further detector segment images of said specimen may be obtained by scanning the beam over said specimen.

12. A non-transitory computer readable medium comprising instructions which, when executed by one or more hardware processors, cause performance of the method steps according to claim 8, 9, 10 or 11.

Fig. 1

51b 51c

51a 51d

57 B'

51h 51e

55 51g 51f 56

Z ⊗ → X

↓
Y

Fig. 2

B₁          B₂          B₃

X

S

P₁          P₂          P₃

B"₁,₂,₃

32                              B'

Fig. 3a

100

101    102    103

s₁    s₂    s₃

X

Fig. 3b

Fig. 4a

Fig. 4b

Fig. 4c

Fig. 5a

Fig. 5b

Europäisches
Patentamt

European
Patent Office

Office européen
des brevets

# EUROPEAN SEARCH REPORT

Application Number

EP 18 20 0039

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/225580 A1 (KOHNO YUJI [JP]) 4 August 2016 (2016-08-04) * paragraphs [0003] - [0021], [0027] - [0120]; figures * ----- | 1-12 | INV. H01J37/153 |
| X | JP 2012 022971 A (UNIV TOKYO; JEOL LTD) 2 February 2012 (2012-02-02) * abstract; figures * ----- | 1-12 | |
| X | US 2017/236684 A1 (KOHNO YUJI [JP]) 17 August 2017 (2017-08-17) * paragraphs [0003] - [0011], [0057] - [0159]; figures * ----- | 1-12 | |

TECHNICAL FIELDS
SEARCHED      (IPC)

H01J

The present search report has been drawn up for all claims

| Place of search | Date of completion of the search | Examiner |
|---|---|---|
| Munich | 9 April 2019 | Krauss, Jan |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.........................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 18 20 0039

This annex lists the patent family members relating to the patent documents cited in the above-mentioned European search report.
The members are as contained in the European Patent Office EDP file on
The European Patent Office is in no way liable for these particulars which are merely given for the purpose of information.

09-04-2019

| Patent document cited in search report | Publication date | Patent family member(s) | Publication date |
|---|---|---|---|
| US 2016225580 A1 | 04-08-2016 | JP 2016143581 A<br>US 2016225580 A1 | 08-08-2016<br>04-08-2016 |
| JP 2012022971 A | 02-02-2012 | JP 5499282 B2<br>JP 2012022971 A | 21-05-2014<br>02-02-2012 |
| US 2017236684 A1 | 17-08-2017 | JP 2017139115 A<br>US 2017236684 A1 | 10-08-2017<br>17-08-2017 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **KIMOTO, K ; ISHIZUKA, K.** Spatially resolved diffractometry with atomic-column resolution. *Ultramicroscopy,* 2011, vol. 111, 1111-1116